# EUROPÄISCHE PATENTSCHRIFT

(11) **EP 2 792 222 B1**
(45) Veröffentlichungstag und Bekanntmachung des Hinweises auf die Patenterteilung: **12.09.2018**
(21) Anmeldenummer: 12795763.7
(22) Anmeldetag: 20.11.2012
(51) Int. Cl.: H05K 1/11, H05K 3/30, H05K 3/34, H05K 1/02, H05K 5/00

(54) **STEUERGERÄT FÜR EIN KRAFTFAHRZEUG**
CONTROL UNIT FOR A MOTOR VEHICLE
APPAREIL DE COMMANDE D'UN VÉHICULE AUTOMOBILE

(30) Priorität: 13.12.2011 DE 102011088335
(43) Veröffentlichungstag der Anmeldung: 22.10.2014
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2012/073069
(87) Internationale Veröffentlichungsnummer: WO 2013/087371

(56) Entgegenhaltungen:
- EP-A2- 0 420 050
- WO-A1-2008/049724
- JP-A- 10 224 019
- US-A- 4 735 582
- US-A- 4 826 068
- US-A- 5 051 813
- US-A- 5 354 207

## Beschreibung

### Stand der Technik

Zur Steuerung von diversen Anwendungen im Kraftfahrzeugbau sind elektronische Steuerungsgeräte erforderlich. Die elektronischen Steuergeräte enthalten elektrische Bauelemente wie Steuerungsmodule zum Ansteuern von Aktuatoren und Sensoren sowie wenigstens eine Steckverbindung zum Anschluss an einen Fahrzeugkabelbaum. Derartige Steuerungsmodule sind beispielsweise zur Steuerung von Schaltvorgängen moderner Automatikgetriebe erforderlich, die in vielen Fällen im Inneren des Getriebegehäuses angeordnet sind. Hierbei werden die Steuerungsmodule so verbaut, dass sie ganz oder teilweise von Getriebeöl bedeckt sind und Temperaturen von -40 C bis +150 C, die in derartigen Getrieben auftreten können, ausgesetzt sind. Bekannt ist, derartige Steuerungsmodule, die bis 100 Anschlusspins und mehr aufweisen können, nicht als THT(through-hole technology)-Bauelement, also mit Anschlusspins zu versehen, die durch eine Leiterplatte hindurchgesteckt werden, sondern als SMD(surface-mounted device)-Bauelement auszubilden und mit einer entsprechenden Leiterplatte elektrisch leitfähig zu verbinden. Allerdings hat sich vereinzelt gezeigt, dass nach dem Lötprozess des Steuergeräts nicht alle Anschlusspins mit den Lötflächen der Leiterplatte elektrisch leitfähig verbunden waren oder dass nicht alle Lötstellen optimal ausgebildet waren.

Aus der WO 2008/049724 A1 ist ein Gehäuse für ein elektronisches Steuergerät bekannt, bei der verschiedene elektronische Bauteile im Innern des Gehäuses über Direktkontakte mit der Leiterplatte verbunden sind.

Aus der US 5,354,207 ist eine Vorrichtung bekannt, die dazu geeignet ist, elektrische Kontaktbeinchen von elektronischen Bauteilen vor dem Lötprozess auf einem Trägersubstrat auszurichten und niederzuhalten.

Aus der EP 0 420 050 A2 ist ein Verfahren bekannt, durch welches beim Auflöten von Bauelementen auf Leiterplatten eine weitgehend reproduzierbare Lötung mit gleichbleibend hoher Qualität zwischen den Anschlussbeinchen der Bauelemente und den Leiterbahnen oder Anschlusspads der Leiterplatte erzielt wird.

In der JP 10 224019 A wird ein Verfahren beschrieben, mit welchem sich beim Laserlöten von Kontaktbeinchen elektrischer Bauelemente auf Leiterplatten der Laserstrahl akkurat auf die Lötstelle ausrichten lässt und ein möglichst geringer Energieverlust an der Lötstelle entsteht.

Aus der US 4,826,068 ist eine Vorrichtung bekannt, bei der Stützelemente unter Anschlussbeinchen eines elektronischen Bauelements das Anlöten der elektrischen Anschlussbeinchen an ein Trägersubstrat optimieren, indem mittels der Stützelemente zuverlässig und reproduzierbar die zur Überwindung eines Höhenunterschieds zwischen dem Trägersubstrat und dem elektronischen Bauelement notwendige Biegung der Anschlussbeinchen eingestellt wird.

### Zusammenfassung der Erfindung

Es kann also ein Bedürfnis bestehen, ein Steuergerät bereitzustellen, bei dem die Anschlusspins des SMD-Bauelements nach dem Lötprozess sicher elektrisch leitfähig mit den Lötflächen der Leiterplatte verbunden sind.

Dieses Bedürfnis kann befriedigt werden durch die Gegenstände der unabhängigen Patentansprüche. Vorteilhafte Ausgestaltungen der Erfindung ergeben sich durch die Gegenstände der abhängigen Patentansprüche.

Gemäß einem ersten Ausgestaltungsbeispiel der Erfindung wird ein Steuergerät für ein Kraftfahrzeug nach Anspruch 1 bereitgestellt.

Der Anschlusspin des elektrischen SMD-Bauelements ist zur stoffschlüssigen Verbindung mit der Lötfläche in Oberflächenmontage ausgebildet. Der Anschlusspin ist in der Regel mittels Lot verzinnt. Das elektrische SMD-Bauelement kann bis zu einhundert und mehr Anschlusspins aufweisen und als ein Steuerungsmodul ausgebildet sein, welches Schaltvorgänge innerhalb eines Automatikgetriebes eines Kraftfahrzeugs steuert. In einer Ausgangsphase, wenn der Anschlusspin noch nicht an die Leiterplatte, respektive an die Lötfläche gelötet ist, drückt der Niederhalter den Anschlusspin an die verzinnte Lötfläche, wobei der Niederhalter hierbei vorgespannt sein kann. Durch den Niederhalter kann vermieden werden, dass einer der Anschlusspins, der in seiner Ausgangslage nicht an der verzinnten Lötfläche anliegen würde, beispielsweise zum Löten durch eine Thermode an die Lötfläche angedrückt würde und nach dem Entfernen einer Thermode aufgrund von Rückfedereigenschaften des Anschlusspins in seine Ausgangslage zurückfedern und sich hierbei aus dem noch flüssigen Lot ziehen würde. Mittels einer Thermode wird der Anschlusspin an die verzinnte Lötfläche der Leiterplatte angedrückt und die sich auf der Lötfläche befindende Lötpaste verflüssigt. Die heiße Thermode wird aus dem noch flüssigen Lot herausgezogen. Hierdurch kühlt aufgrund des Wärmeentzugs das flüssige Lot ab und verfestigt sich. Da nach dem Zurückziehen der Thermode das Lot noch eine gewisse Zeit flüssig ist, kann sich hierbei der Anschlusspin aufgrund von Rückstellkräften aus dem flüssigen Lot zurückziehen. Wenn nun beispielsweise die Thermode verzundert ist, kann möglicherweise ein schlechter Wärmeübergang von der Thermode zu dem Anschlusspin stattfinden. Zwar kann hierbei das Lot durch die Thermode möglicherweise verflüssigt werden, jedoch reicht die erreichte Temperatur nicht aus, dass sich die Thermode beim Zurückziehen von dem Anschlusspin lösen kann. Somit kann der Anschlusspin bei einem Zurückziehen der Thermode aus dem flüssigen Lot möglicherweise ebenfalls aus dem flüssigen Lot zurückgezogen werden. Bei Verwendung einer berührungslosen Verflüssigung des Lots oder der Lotpaste beispielsweise durch Lichtstrahl oder Laserstrahl wird zwar ein Anhaften der Thermode an dem Anschlusspin oder ein schlechter Wärmeübergang durch eine Verzunderung der Thermodenoberfläche vermieden. Jedoch können einzelne Anschlusspins aufgrund von Form- und Lagetoleranzen oder aufgrund einer Verformung durch fehlerhaftes Handling des Bauelements nicht ausreichend nah an der Lötfläche der Leiterplatte verlagert sein, so dass ein ordnungsgemäßes Löten nicht stattfindet. Dies führt zu einem Ausfall des elektrischen SMD-Bauelements. Die Leiterplatte kann starr oder flexibel ausgebildet sein. Wenn die Leiterplatte flexibel ausgestaltet ist, dann wird die Leiterplatte in der Regel durch ein Stützelement gestützt sein, so dass der Niederhalter den Anschlusspin an der Lötfläche positionieren kann. Wenn die Leiterplatte starr ausgebildet ist, wird es sich in der Regel um Leiterplatten in FR4-Ausführung oder mehr, also um Leiterplatten aus glasfaserverstärktem Epoxydharz, handeln. Der Niederhalter wird in der Ausgangsphase, also vor dem Lötprozess, mit der Leiterplatte fest verbunden und verbleibt an dieser über die gesamte Lebensdauer des Steuergeräts. Durch den Niederhalter kann also vermieden werden, dass der Anschlusspin entweder aufgrund von Rückstellkräften oder aufgrund einer verzunderten Thermode aus dem flüssigen Lot gezogen wird. Vielmehr kann der Kontaktniederhalter sicherstellen, dass der Anschlusspin und die Leiterplatte einen vorbestimmten Abstand voneinander aufweisen, so dass die Lötstelle optimal ausgeführt werden kann. Nur eine optimal ausgeführte Lötstelle stellt eine ausreichende mechanische Belastbarkeit bezüglich auftretender Zug- und/oder Scherkräfte sicher. Diese mechanische Belastbarkeit ist notwendig, damit die Lötstelle, insbesondere, wenn sie mit Schwingungen beaufschlagt ist, während des Betriebs nicht zerrüttet wird. Weiterhin kann der Kontaktniederhalter bei Schwingungsbelastung dämpfend auf die Lötstelle einwirken. Auch dies kann einer Zerrüttung der Lötstelle während des Betriebs wirkungsvoll entgegenwirken. Weiterhin kann der Kontaktniederhalter auch für Anschlusspins von Bauelementen verwendet werden, die in einem Reflow-Ofen gelötet werden können. Damit der Kontaktniederhalter seine schwingungsdämpfende Wirkung erzeugen kann, wird der Kontaktniederhalter in der Regel auch nach dem Lötprozess auf den Anschlusspin drücken, also eine vorbestimmte Vorspannung aufweisen.

Gemäß einem weiteren Ausgestaltungsbeispiel der Erfindung weist der Anschlusspin eine erste Fläche und eine der ersten Fläche gegenüberliegende zweite Fläche auf. Die erste Fläche ist der Lötfläche zugewandt. Auf die zweite Fläche ist durch den Kontaktniederhalter eingewirkt.

Durch eine derartige Anordnung wird der Anschlusspin in Richtung der Lötfläche gedrückt und nicht etwa in Richtung der Lötstelle gezogen. Dies erleichtert die Ausgestaltung des Kontaktniederhalters und dessen Herstellung.

Gemäß einem weiteren Ausgestaltungsbeispiel der Erfindung weist die zweite Fläche eine erste Teilfläche und eine der ersten Teilfläche benachbarte zweite Teilfläche auf. Die erste Teilfläche ist einem Gehäuse des elektrischen SMD-Bauelements zugewandt. Die zweite Teilfläche ist von dem Gehäuse des elektrischen SMD-Bauelements abgewandt. Der Lötprozess ist mittels eines Verfahrens, ausgewählt aus der Gruppe Laserstrahllöten, Lichtstrahllöten und Thermodenlöten, auf der zweiten Teilfläche ausführbar.

Hierdurch ist der Lötprozess durch den Kontaktniederhalter nicht behindert. Vielmehr ist der Kontaktniederhalter derart an dem Anschlusspin angeordnet, dass er nicht in Kontakt mit dem Laserstrahl, dem Lichtstrahl oder der Thermode gerät.

Gemäß einem weiteren Ausgestaltungsbeispiel der Erfindung weist der Kontaktniederhalter des Steuergeräts eine in Richtung der zweiten Fläche weisende Unterseite auf. Ein erster Abstand erstreckt sich senkrecht zur Leiterplatte zwischen der verzinnten Lötfläche und einer der verzinnten Lötfläche zugewandten Oberseite der Leiterplatte. Ein zweiter Abstand erstreckt sich senkrecht zur Leiterplatte zwischen der ersten Fläche und der zweiten Fläche des Anschlusspins. Der Abstand der Unterseite von der Leiterplatte ist zusammengesetzt aus einer Summe aus dem ersten Abstand und dem zweiten Abstand.

Der sich zwischen der Unterseite des Kontaktniederhalters und der Oberseite der Leiterplatte ergebende Abstand kann sich zusammensetzen aus dem sich geringstmöglich ergebenden ersten Abstand und dem sich geringstmöglich ergebenden zweiten Abstand. Somit können sich der erste Abstand und der zweite Abstand auf die Komponenten mit einer geringstmöglichen Dicke beziehen. Somit kann, wenn nur die geringsten Dicken die Summe der beiden Abstände bilden, der Kontaktniederhalter vorspannungslos gegenüber dem Anschlusspin sein. Eine derartige Konstellation kann jedoch aus Wahrscheinlichkeitsgründen praktisch ausgeschlossen werden, so dass der Kontaktniederhalter in der Regel immer auf den Anschlusspin drücken wird. Wenn zusätzlich Lötstopplack an der Oberseite der Leiterplatte aufgetragen ist und der Niederhalter auf einer der Oberseite der Leiterplatte abgewandten Oberseite des Lötstopplacks montiert ist, kann sich der Abstand um einen dritten Abstand verringern, der sich zwischen der Oberseite der Leiterplatte und der Oberseite des Lötstopplacks senkrecht zur Leiterplatte erstreckt.

Gemäß einem weiteren Ausgestaltungsbeispiel der Erfindung ist die Unterseite des Kontaktniederhalters plan und im Wesentlichen parallel zur Oberseite der Leiterplatte ausgebildet.

Somit kann auf den Anschlusspin flächig gedrückt werden. Natürlich kann die Unterseite beispielsweise auch kugelförmig ausgestaltet sein, so dass der Anschlusspin lediglich punktuell angedrückt wird. Ein flächiges Andrücken bietet jedoch den Vorteil, dass auch eine geringfügige Verdrehung des Anschlusspins gegenüber der Lötfläche durch den Kontaktniederhalter ausgeglichen werden kann.

Durch die Kammerwände kann verhindert sein, dass während des Lötvorgangs evtl. entstehende Lötspritzer einander benachbarte Anschlusspins elektrisch leitfähig brücken und damit einen Kurzschluss herbeiführen können. Weiterhin kann durch die Kammerwände verhindert werden, dass elektrisch leitfähige Späne während des Betriebs zwei Anschlusspins brücken können. Auch bieten die Kammerwände in Verbindung mit dem Kontaktniederhalter einen Schutz der Anschlusspins beim Transport des ungelöteten Steuergeräts beispielsweise zu der Lötstation.

Gemäß einem weiteren Ausgestaltungsbeispiel der Erfindung sind die erste Kammerwand, die zweite Kammerwand und der Niederhalter H-förmig angeordnet.

In der Regel bilden hierbei die Kammerwände die Schenkel und der Niederhalter das Mittelteil. Insbesondere durch eine solche Ausgestaltung können die Kammerwände derart positioniert sein, dass sie länger ausgestaltet sind als die Länge der Lötfläche. Hierbei können die Kammerwände sowohl in Richtung des Gehäuses des SMD-Bauelements als auch in die entgegengesetzte Richtung die Lötfläche überragen.

Gemäß einem weiteren Ausgestaltungsbeispiel der Erfindung ist eine Querwandung unlösbar mit der ersten Kammerwand und der zweiten Kammerwand verbunden. Die Querwandung erstreckt sich im Wesentlichen parallel zu dem Kontaktniederhalter. Die Querwandung ist von dem Kontaktniederhalter beabstandet. Die Querwandung ist von dem Gehäuse des elektrischen SMD-Bauelements weiter beabstandet als der Kontaktniederhalter. Die Querwandung ist fest mit der Leiterplatte verbunden. Die erste Kammerwand, die zweite Kammerwand, die Querwandung, der Kontaktniederhalter und die Leiterplatte begrenzen einen Raum, wobei in den Raum fluiddichtes Material einbringbar ist.

Dieses Material kann beispielsweise mittels eines Dispensers eingebracht werden. Das fluiddichte Material kann beispielsweise Lack oder eine Vergussmasse, insbesondere eine elastisch reversibel verformbare Vergussmasse, sein. Insbesondere eine elastisch reversibel verformbare Vergussmasse bietet den Vorteil, dass sie Relativbewegung der einzelnen Komponenten zueinander aufgrund unterschiedlicher Wärmeausdehnungskoeffizienten ausgleichen kann.

Gemäß einem weiteren Ausgestaltungsbeispiel der Erfindung sind die erste Kammerwand, die zweite Kammerwand und der Kontaktniederhalter in einem Rahmen ausgebildet. Das elektrische SMD-Bauelement ist von dem Rahmen ringförmig umgeben.

Dadurch, dass der Rahmen ein geschlossenes Gebilde darstellt, ist er verwindungssteif. Dies kann ein Hantieren des Rahmens erleichtern. Insbesondere ist durch die Geschlossenheit ein Verhängen des Rahmens in weitere komponenten weitgehend vermieden.

Gemäß einem weiteren Ausgestaltungsbeispiel der Erfindung ist der Rahmen des Steuergeräts mit der Leiterplatte fest verbunden.

Die feste Verbindung kann beispielsweise durch Kleben, Clipsen, Nieten oder Schrauben erfolgen. Wenn die Leiterplatte mit Lötstopplack abgedichtet ist, dann ist der Rahmen in der Regel auf dem Lötstopplack aufliegend.

Gemäß einem weiteren Ausgestaltungsbeispiel der Erfindung ist der Rahmen des Steuergeräts aus einem elektrisch nicht leitfähigen Material hergestellt.

Damit müssen vor einer Montage des Rahmens, respektive des Kontaktniederhalters, die einzelnen Anschlusspins nicht elektrisch isoliert werden. Insbesondere bietet sich an, den Rahmen in Spritzgusstechnik aus Kunststoff, welcher auch faserverstärkt sein kann, zu fertigen.

Gemäß einem weiteren Ausgestaltungsbeispiel der Erfindung ist der Rahmen aus Polyamid 4 (PA4) gefertigt.

Insbesondere dieses Polyamid ist für einen derartigen Einsatz zweckprädestiniert, da es darüber hinaus wärmestabilisiert ist. Damit können die Temperaturen, die während des Lötprozesses und während des Betriebs in dem Automatikgetriebe auftreten, diesen Werkstoff nicht schädigen.

Gemäß einem weiteren Ausgestaltungsbeispiel der Erfindung ist ein Bauelementniederhalter an dem Rahmen fest verbunden, wobei das elektrische SMD-Bauelement durch den Bauelementniederhalter in Richtung der Leiterplatte niedergedrückt ist.

Hierdurch ist keine eigene Fixierung des elektrischen SMD-Bauelements wie beispielsweise durch Kleben erforderlich. Ferner kann bei einer Montage des Rahmens an die Leiterplatte das elektrische SMD-Bauelement mittels des Rahmens sowohl positioniert als auch fixiert werden. Es ist nicht erforderlich, dass hierbei das elektrische SMD-Bauelement an der Leiterplatte anliegen muss. Auch kann die Leiterplatte eine Öffnung aufweisen, in der das elektrische SMD-Bauelement angeordnet ist. Hierbei wird die Leiterplatte das elektrische SMD-Bauelement in der Regel umgeben. Die Leiterplatte ihrerseits kann auf einer durchgehenden Trägerplatte unlösbar verbunden sein. Somit kann das elektrische SMD-Bauelement durch den Bauelementniederhalter an die Trägerplatte gut wärmeleitfähig angedrückt sein. Die Trägerplatte kann beispielsweise aus einer Aluminiumlegierung gefertigt sein und als Wärmesenke dienen. Durch einen direkten Kontakt des elektrischen SMD-Bauelements an der Trägerplatte entfallen Wärmewiderstände zwischen der Trägerplatte und dem elektrischen SMD-Bauelement. Ein Wärmewiderstand könnte beispielsweise eine Klebestelle zwischen der Trägerplatte und dem elektrischen SMD-Bauelement darstellen.

Gemäß einem weiteren Ausgestaltungsbeispiel der Erfindung ist die Leiterplatte an eine Trägerplatte unlösbar verbunden. Die Leiterplatte weist eine Öffnung auf, wobei das elektrische SMD-Bauelement in der Öffnung angeordnet ist. Das elektrische SMD-Bauelement ist mit der Trägerplatte gut wärmeleitfähig verbunden.

Das elektrische SMD-Bauelement kann mit der Trägerplatte beispielsweise mittels eines wärmeleitfähigen Klebstoffs verklebt sein. Hierdurch kann die von dem elektrischen SMD-Bauelement erzeugte Wärme schnell in die Trägerplatte, welche als Wärmesenke fungiert, eingeleitet werden. Auch ist es möglich, dass der Bauelementniederhalter des Rahmens das elektrische SMD-Bauelement an die Trägerplatte drückt. Hierbei ist das elektrische SMD-Bauelement an der Trägerplatte derart fixiert, dass Schwingungen sowie Beschleunigungskräfte die Lage des elektrischen SMD-Bauelements zu der Leiterplatte, respektive zu den Lötstellen nicht verändern können.

Gemäß einem weiteren Ausgestaltungsbeispiel der Erfindung ist das elektrische SMD-Bauelement für ein Lötverfahren im Reflow-Ofen ungeeignet.

Somit können auch elektrische SMD-Bauelemente verarbeitet werden, die intern bereits Lötstellen aufweisen, die bei einem Lötprozess in einem Reflow-Ofen ansonsten möglicherweise geschädigt werden könnten. Somit kann das elektrische SMD-Bauelement als eine vollständige Steuerelektronik ausgebildet sein.

Gemäß einem weiteren Ausgestaltungsbeispiel der Erfindung wird ein Automatikgetriebe mit einem vorhergehend beschriebenen Steuergerät bereitgestellt. Das Automatikgetriebe weist ein Getriebegehäuse auf, wobei das Steuergerät in dem Getriebegehäuse angeordnet ist.

Es wird angemerkt, dass Gedanken zu der Erfindung hierin im Zusammenhang sowohl mit einem Steuergerät für ein Kraftfahrzeug als auch mit einem Automatikgetriebe beschrieben sind. Einem Fachmann ist hierbei klar, dass die einzelnen beschriebenen Merkmale auf verschiedene Weise miteinander kombiniert werden können, um so auch zu anderen Ausgestaltungen der Erfindung zu gelangen.

### Kurze Beschreibung der Zeichnungen

Ausführungsformen der Erfindung werden nachfolgend mit Bezug auf die beigefügten Figuren beschrieben. Die Figuren sind lediglich schematisch und nicht maßstabsgetreu.
- Figur 1: zeigt ein Steuergerät nach dem Stand der Technik, bei dem ein elektrisches SMD-Bauelement mit einer Trägerplatte verbunden ist und dessen Anschlusspins mit Lötflächen einer Leiterplatte stoffschlüssig verbunden sind, im Querschnitt;
- Figur 2: zeigt eine Anordnung nach dem Stand der Technik mit einem fehlerhaft gelöteten Anschlusspin und einer Löt-Thermode während des Lötvorgangs in einer Frontansicht;
- Figur 3: zeigt ein Steuergerät, bei dem das elektrische SMD-Bauelement mit der Trägerplatte verbunden ist, wobei ein Anschlusspin des elektrischen SMD-Bauelements an die verzinnte Lötfläche der Leiterplatte mittels eines Kontaktniederhalters gedrückt ist, in einer Seitenansicht;
- Figur 4: zeigt das aus Figur 3 bekannte Steuergerät in einer Frontansicht;
- Figur 5: zeigt das aus den Figuren 3 und 4 bekannte Steuergerät in einer 3D-Ansicht; und
- Figur 6: zeigt das aus Figur 5 bekannte Steuergerät in einem Automatikgetriebe angeordnet, in einem Röntgenblick.

### Detaillierte Beschreibung einer beispielhaften Ausführungsform

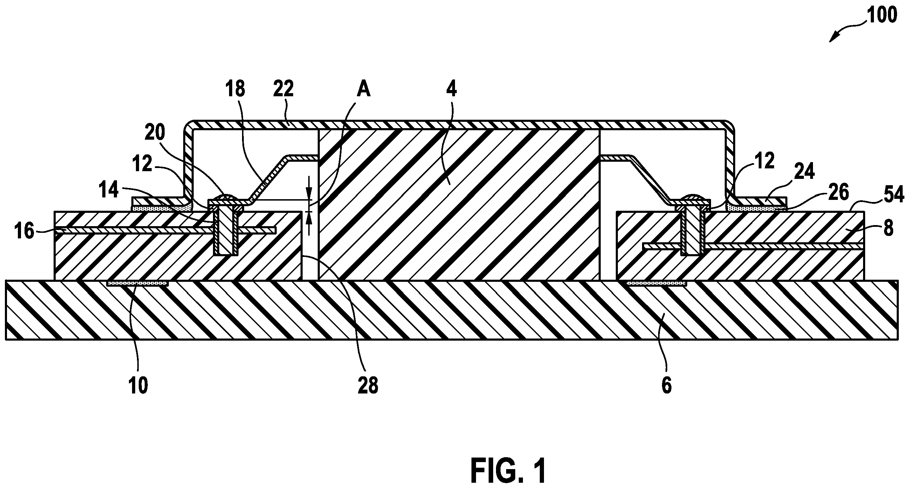

Figur 1 zeigt ein Steuergerät 100 nach dem Stand der Technik. Hierbei ist ein elektrisches SMD(surface-mounted device)-Bauelement 4 mit einer Trägerplatte 6 fest verbunden. Mit der Trägerplatte 6 ist eine Leiterplatte 8 mittels einer ersten umlaufenden Klebung 10 fluiddicht fest verbunden. Die Leiterplatte 8 besitzt an ihrer Oberseite 54, die der Trägerplatte 6 abgewandt ist, eine Lötfläche 12. Die Lötfläche 12 ist elektrisch leitfähig verbunden mit einer VIA(Vertical-Interconnect-Access) 14, also einer senkrechten Durchverbindung zwischen elektrisch leitfähigen Schichten innerhalb der Leiterplatte 8. Die VIA 14 ist in dem vorliegenden Ausführungsbeispiel mit einer sich innerhalb der Leiterplatte 8 erstreckenden elektrisch leitfähigen Leiterbahn 16 elektrisch leitfähig verbunden. Das elektrische SMD-Bauelement 4 besitzt einen ersten Anschlusspin 18, der mittels Lots 20 mit der Lötfläche 12 elektrisch leitfähig verbunden ist. Hierbei besitzt der erste Anschlusspin 18 einen vorbestimmten Abstand A zu der Leiterplatte 8, respektive deren Oberseite 54. Ein wannenförmig ausgestalteter Spanschutzdeckel 22 mit einem der Leiterplatte 8 zugewandten Rand 24 ist mit der Leiterplatte 8 fluiddicht verbunden, indem der Rand 24 mittels einer zweiten umlaufenden Klebung 26 mit der Oberseite 54 der Leiterplatte 8 verklebt ist. Die Leiterplatte 8 besitzt eine Öffnung 28, in der das elektrische SMD-Bauelement 4 angeordnet ist. Somit wird das elektrische SMD-Bauelement 4 von der Leiterplatte 8 umlaufend umgeben. Durch diese Anordnung ist das elektrische SMD-Bauelement 4 vor einem das Steuergerät 100 umgebenden Fluid geschützt.

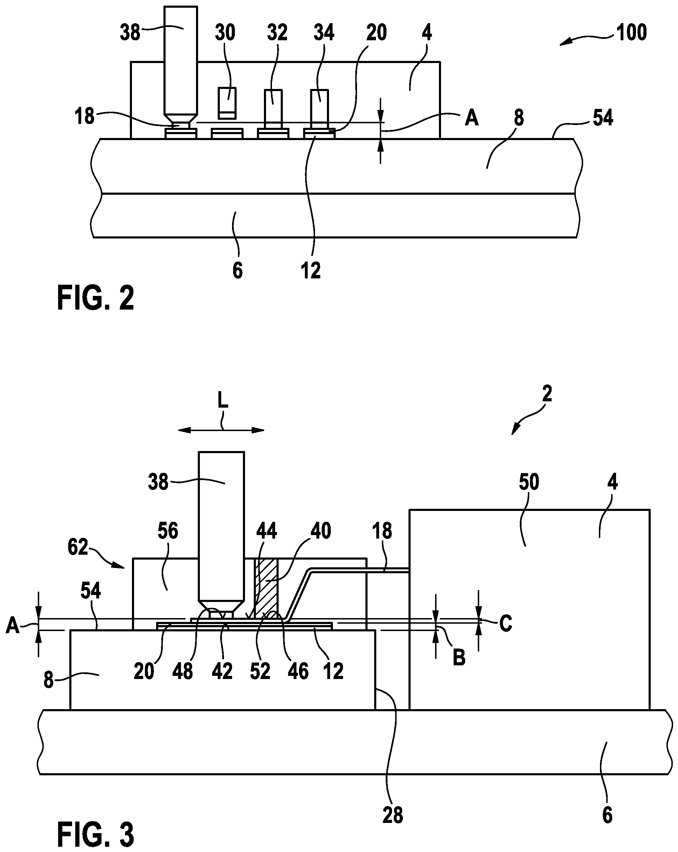

Figur 2 zeigt eine Anordnung nach dem Stand der Technik mit einem fehlerhaft gelöteten zweiten Anschlusspin 30 nach dem Lötprozess. Hierbei sind neben dem ersten Anschlusspin 18 ein zweiter Anschlusspin 30, ein dritter Anschlusspin 32 und ein vierter Anschlusspin 34 angeordnet. In der linken Darstellung ist ersichtlich, wie eine Thermode 38 den ersten Anschlusspin 18 an die mit dem Lot 20 verzinnte Lötfläche 12 drückt. Bei den rechts von dem ersten Anschlusspin 18 dargestellten Anschlusspins 30, 32, 34 wurde der Lötprozess mittels der Thermode 38 bereits durchgeführt. Um eine optimale Lötstelle an dem elektrischen SMD-Bauelement 4 zu erzeugen, ist es notwendig, dass der Anschlusspin 18, 30, 32, 34 einen vorbestimmten Abstand A von der Oberseite 54 der Leiterplatte 8 besitzt. In dem hier vorliegenden Ausführungsbeispiel ist der vorbestimmte Abstand A dargestellt, wobei lediglich der erste 18, der dritte 32 und der vierte Anschlusspin 34 den geforderten vorbestimmten Abstand A einhalten. Der zweite Anschlusspin 30 überschreitet den vorbestimmten Abstand A derart, dass nach dem Lötprozess durch die Thermode 38 keine elektrisch leitfähige Verbindung zu der Lötfläche 12 vorhanden ist. Vielfach ist dies darauf zurückzuführen, dass bereits zu Beginn der Lötung der zweite Anschlusspin einen zu großen Abstand A zu der Lötfläche 12 besaß. Durch das Thermodenlöten wurde zwar der zweite Anschlusspin 30 durch die Thermode 38 an die Lötfläche 12 gedrückt und hierbei das Lot 20 verflüssigt, jedoch zogen nach dem Entfernen der Thermode 38 Rückstellkräfte, die in dem zweiten Anschlusspin 30 vorhanden sind, den zweiten Anschlusspin 30 aus dem flüssigen Lot 20.

Figur 3 zeigt ein Steuergerät 2, bei dem ebenfalls das elektrische SMD-Bauelement 4 mit der Trägerplatte 6 verbunden ist. In Figur 3 sowie in den folgenden Figuren ist aus Übersichtlichkeitsgründen auf die Darstellung eines Lötlacks auf der Oberseite 54 der Leiterplatte 8 verzichtet. Der erste Anschlusspin 18 ist an die mittels Lot 20 verzinnte Lötfläche 12 mittels eines Kontaktniederhalters 40 gedrückt. Der erste Anschlusspin 18 besitzt eine erste Fläche 42, die der Lötfläche 12 zugewandt ist, und eine der ersten Fläche 42 gegenüberliegende zweite Fläche 44. Die zweite Fläche 44 ist in eine erste Teilfläche 46 und eine zweite Teilfläche 48 gegliedert, wobei die erste Teilfläche 46 einem Gehäuse 50 des elektrischen SMD-Bauelements 4 zugewandt ist. Die zweite Teilfläche 48 ist der ersten Teilfläche 46 benachbart und erstreckt sich entsprechend von dem Gehäuse 50 des elektrischen SMD-Bauelements 4 weg. Der Kontaktniederhalter 40 drückt auf die erste Teilfläche 46 und somit auf die zweite Fläche 44. Der Lötprozess wird an der zweiten Teilfläche 48 ausgeführt. In dem hier vorliegenden Ausführungsbeispiel erfolgt der Lötprozess durch die bereits bekannte Thermode 38. Der Lötprozess kann jedoch auch durch Lichtstrahl oder Laserstrahl durchgeführt werden. Der Kontaktniederhalter 40 besitzt eine Unterseite 52, die in dem hier vorliegenden Ausführungsbeispiel plan und im Wesentlichen parallel zu der Oberseite 54 der Leiterplatte 8 ausgebildet ist. Durch eine derartige Gestaltung der Unterseite 52 können geringe Verdrehungen des ersten Anschlusspins 18 gegenüber der Lötfläche 12 ausgeglichen werden. Ferner ist eine erste Kammerwand 56 an dem Kontaktniederhalter 40 unlösbar verbunden. Die erste Kammerwand 56 ist an die Oberseite 54 der Leiterplatte 8 fest verbunden. Weiterhin sind der Kontaktniederhalter 40 und die erste Kammerwand 56 in einen Rahmen 62 integriert. Darüber hinaus ist ersichtlich, dass sich die erste Kammerwand 56 in einer Längserstreckungsrichtung L des ersten Anschlusspins 18 erstreckt. Weiterhin überragt die erste Kammerwand 56 die Lötfläche 12 in beiden Richtungen der Längserstreckungsrichtung L. Ferner erstreckt sich hier die erste Kammerwand 56 senkrecht zu der Oberseite 54 der Leiterplatte 8 höher als der erste Anschlusspin 18. Die Unterseite 52 des Kontaktniederhalters 40 ist mit dem vorbestimmten Abstand A von der Oberseite 54 der Leiterplatte 8 beabstandet. Der vorbestimmte Abstand A ist die Summe aus einem ersten Abstand B und einem zweiten Abstand C. Der erste Abstand B erstreckt sich senkrecht auf die Oberseite 54 der Leiterplatte 8 zwischen der mit Lot 20 verzinnten Lötfläche 12 und der Oberseite 54 der Leiterplatte 8. Der zweite Abstand C erstreckt sich senkrecht auf die Oberseite 54 der Leiterplatte 8 zwischen der ersten Fläche 42 und der zweiten Fläche 44 des ersten Anschlusspins 18.

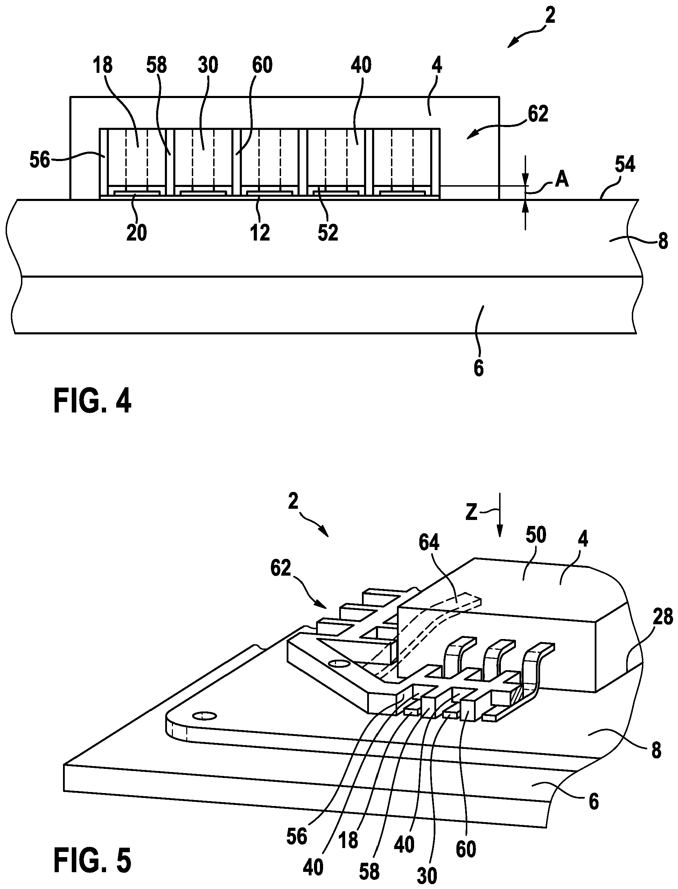

Figur 4 zeigt den aus Figur 3 bekannten Ausschnitt des Steuergeräts 2 in einer Frontansicht. Hierbei sind fünf Anschlusspins 18, 30 nebeneinander angeordnet und besitzen alle den gleichen Abstand A der Unterseite 52 des Kontaktniederhalters 40 von der Oberseite 54 der Leiterplatte 8. Hierdurch kann jeder Anschlusspin 18, 30 von der Oberseite 54 der Leiterplatte 8 gleichermaßen beabstandet an die Lötfläche 12 gelötet werden. Ferner ist der Kontaktniederhalter 40 unlösbar mit einer zweiten Kammerwand 58 verbunden. Zu dem ersten Anschlusspin 18 benachbart ist der zweite Anschlusspin 30 angeordnet. Der zweite Anschlusspin 30 wird ebenfalls durch den Kontaktniederhalter 40 an die mit Lot 20 verzinnte Lötfläche 12 gedrückt. Die erste Kammerwand 56 und die zweite Kammerwand 58 sind zueinander parallel angeordnet und voneinander derart beabstandet, dass sich zwischen der ersten Kammerwand 56 und der zweiten Kammerwand 58 der erste Anschlusspin 18 erstrecken kann. Die hier beschriebene Darstellung ist auch für den zweiten Anschlusspin 30 gültig, der dementsprechend von der zweiten Kammerwand 58 und der dritten Kammerwand 60 flankiert ist. Die Kammerwände 56, 58, 60 sowie die Kontaktniederhalter 40 sind in dem Rahmen 62 integriert, der besser in Figur 5 erkennbar ist.

Figur 5 zeigt nun in einem Ausschnitt das aus den Figuren 3 und 4 bekannte Steuergerät 2 in einer 3D-Ansicht. Deutlich sichtbar ist, wie die Kontaktniederhalter 40 die Anschlusspins 18, 30 niederdrücken. Weiterhin ersichtlich ist, dass die erste 56 und die zweite Kammerwand 58 in Verbindung mit dem Kontaktniederhalter 40 H-förmig ausgebildet sind, wobei die beiden Kammern 56, 58 je einen Schenkel und der Kontaktniederhalter 40 ein Mittelteil ausbilden. An dem Rahmen 62 ist unlösbar ein Bauelementniederhalter 64 verbunden, der hier als gestrichelte Linie dargestellt ist. Dieser Bauelementniederhalter 64 drückt in einer Richtung Z senkrecht in Richtung der Leiterplatte 8 das Gehäuse 50 des elektrischen SMD-Bauelements 4 an die Trägerplatte 6. Somit kann auf eine weitere Fixierung wie beispielsweise eine Verklebung des Gehäuses 50 mit der Trägerplatte 6 verzichtet werden. Dadurch, dass das Gehäuse 50 an der Trägerplatte 6 anliegt, kann von dem elektrischen SMD-Bauelement 4 erzeugte Wärme direkt in die Trägerplatte 6, welche als Wärmesenke ausgebildet ist, eingeleitet werden. Natürlich kann der Rahmen 62 mittels eines Deckels, wie er aus der Figur 1 als Spanschutzdeckel 22 bekannt ist, überspannt werden, so dass eine fluiddichte Verbindung zwischen Deckel und Leiterplatte 8 sowie zwischen Leiterplatte 8 und Trägerplatte 6 geschaffen werden kann. Dementsprechend würde kein das Steuergerät 2 umgebende Fluid an das Bauelement 4 gelangen können. Natürlich könnten auch die Anschlusspins 18, 30 geschützt werden, indem diese beispielsweise mittels Lack und Vergussmasse vor einem Kontakt mit dem Fluid geschützt sind. Die Ausgestaltung der verhindert, dass im Automatikgetriebeöl vorhandene elektrisch leitfähige Späne an die Anschlusspins 18, 30 gelangen können. Auch verhindern die Kammerwände 56, 58, 60, dass während des Lötprozesses Lötspritzer einander benachbarte Anschlusspins 18, 30 brücken und damit im Betrieb einen Kurzschluss erzeugen können. Der Kontaktniederhalter 40 wirkt dämpfend bei einer Schwingbelastung auf die elektrisch leitfähige Verbindung der Anschlusspins 18, 30 mit der Lötfläche 12 und beugt damit einer Zerrüttung dieser Lötstelle während des Betriebs vor. Der Rahmen 62 mit den Kammerwänden 56, 58, 60 und den Kontaktniederhaltern 40 ist einstückig aus Polyamid 4 (PA4) ausgebildet. In dem hier vorliegenden Ausgestaltungsbeispiel ist nur ein Ausschnitt des Rahmens 62 dargestellt. Der Rahmen 62 umgibt das elektrische SMD-Bauelement 4 ringförmig.

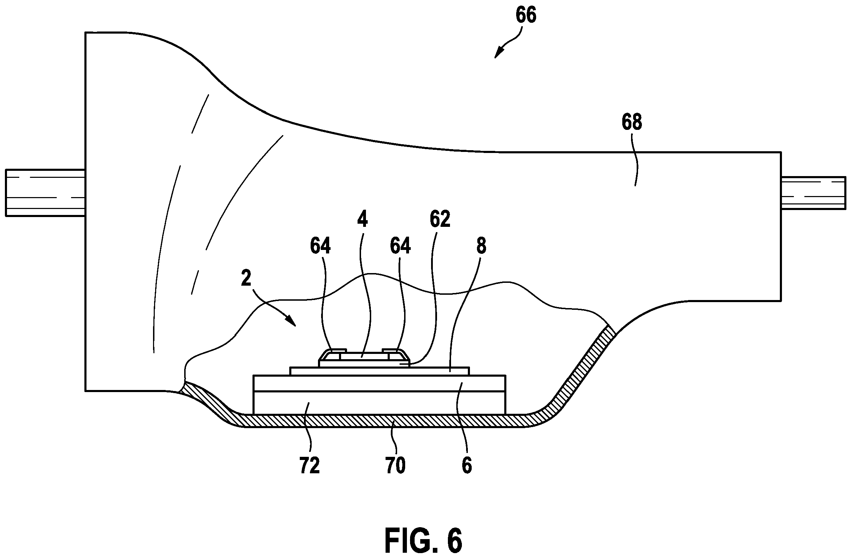

Figur 6 zeigt ein Automatikgetriebe 66 mit einem Getriebegehäuse 68 sowie einer Ölwanne 70. In der Ölwanne 70 ist eine Hydraulikplatte 72 angeordnet, an die die Trägerplatte 6 des Steuergeräts 2 gut wärmeleitfähig verbunden ist. Damit kann während des Betriebs des hier nicht dargestellten Fahrzeugs durch den Fahrtwind die Ölwanne 70 gekühlt werden. Entsprechend wird dann in dem elektrischen SMD-Bauelement 4 erzeugte Wärme in die Trägerplatte 6 eingeleitet und von dort in die Hydraulikplatte 72. Die Hydraulikplatte 72 leitet dann die Wärme in die Ölwanne 70.

## Patentansprüche

1. Steuergerät für ein Kraftfahrzeug, das Steuergerät aufweisend ein elektrisches SMD(surface-mounted device)-Bauelement (4) mit wenigstens einem entsprechenden Anschlusspin (18, 30) und eine Leiterplatte (8), wobei die Leiterplatte (8) wenigstens eine Lötfläche (12) aufweist, wobei die Lötfläche (12) an der Leiterplatte (8) unlösbar verbunden ist, wobei die Lötfläche (12) und der Anschlusspin (18, 30) mittels eines Lötprozesses miteinander stoffschlüssig elektrisch leitfähig verbindbar sind,
**dadurch gekennzeichnet, dass** ein Kontaktniederhalter (40) mit der Leiterplatte (8) fest verbunden ist, wobei der Anschlusspin (18, 30) durch den Kontaktniederhalter (40) derart positioniert ist, dass, wenn der Anschlusspin (18, 30) mit der Lötfläche (12) stoffschlüssig verbunden ist, der Anschlusspin (18, 30) und die Leiterplatte (8) einen vorbestimmten Abstand (A) voneinander aufweisen, und der Kontaktniederhalter (40) unlösbar mit einer ersten Kammerwand (56) und einer zweiten Kammerwand (58) verbunden ist,
wobei sich die erste Kammerwand (56) und die zweite Kammerwand (58) im Wesentlichen parallel zueinander erstrecken,
wobei die erste Kammerwand (56) und die zweite Kammerwand (58) voneinander beabstandet sind,
wobei sich die erste Kammerwand (56) und die zweite Kammerwand (58) im Wesentlichen parallel zu einer Längserstreckungsrichtung (L) des Anschlusspins (18) erstrecken,
wobei sich die erste Kammerwand (56) und die zweite Kammerwand (58) im Wesentlichen senkrecht zu einer Oberseite (54) der Leiterplatte (8) erstrecken,
wobei die erste Kammerwand (56) und die zweite Kammerwand (58) mit der Leiterplatte (8) fest verbunden sind,
wobei sich der Anschlusspin (18) zwischen der ersten Kammerwand (56) und der zweiten Kammerwand (58) erstreckt.

2. Steuergerät nach Anspruch 1,
**dadurch gekennzeichnet, dass**
der Anschlusspin (18, 30) eine erste Fläche (42) und eine der ersten Fläche (42) gegenüberliegende zweite Fläche (44) aufweist,
wobei die erste Fläche (42) der Lötfläche (12) zugewandt ist,
wobei auf die zweite Fläche (44) durch den Kontaktniederhalter (40) eingewirkt ist.

3. Steuergerät nach Anspruch 2,
**dadurch gekennzeichnet, dass**
die zweite Fläche (44) eine ersten Teilfläche (46) und eine der ersten Teilfläche (46) benachbarte zweite Teilfläche (48) aufweist,
wobei die erste Teilfläche (46) einem Gehäuse (50) des elektrischen SMD-Bauelements (4) zugewandt ist,
wobei die zweite Teilfläche (48) von dem Gehäuse (50) des elektrischen SMD-Bauelements (4) abgewandt ist,
wobei der Lötprozess mittels eines Verfahrens ausgewählt aus der Gruppe Laserstrahllöten, Lichtstrahllöten und Thermodenlöten auf der zweiten Teilfläche (48) ausführbar ist.

4. Steuergerät nach Anspruch 3,
**dadurch gekennzeichnet, dass**
die erste Kammerwand (56), die zweite Kammerwand (58) und der Kontaktniederhalter (40) in einem Rahmen (62) ausgebildet sind, wobei das elektrische SMD-Bauelement (4) von dem Rahmen (62) ringförmig umgeben ist.

5. Steuergerät nach Anspruch 4,
**dadurch gekennzeichnet, dass**
der Rahmen (62) mit der Leiterplatte (8) fest verbunden ist.

6. Steuergerät nach Anspruch 4 oder 5,
**dadurch gekennzeichnet, dass**
der Rahmen (62) aus einem elektrisch nicht leitfähigen Material hergestellt ist.

7. Steuergerät nach einem der Ansprüche 4 bis 6,
**dadurch gekennzeichnet, dass**
ein Bauelementniederhalter (64) an dem Rahmen (62) fest verbunden ist,
wobei das elektrische SMD-Bauelement (4) durch den Bauelementniederhalter (64) in Richtung (Z) der Leiterplatte (8) niedergedrückt ist.

8. Steuergerät nach einem der vorhergehenden Ansprüche,
**dadurch gekennzeichnet, dass**
die Leiterplatte (8) an eine Trägerplatte (6) unlösbar verbunden ist,
wobei die Leiterplatte (8) eine Öffnung (28) aufweist,
wobei das elektrische SMD-Baulement (4) in der Öffnung (28) angeordnet ist,
wobei das elektrische SMD-Bauelement (4) mit der Trägerplatte (6) gut wärmeleitfähig verbunden ist.

9. Automatikgetriebe mit einem Steuergerät nach einem der vorhergehenden Ansprüche,
**dadurch gekennzeichnet, dass**
das Automatikgetriebe (68) ein Getriebegehäuse (68) aufweist,
wobei das Steuergerät (2) in dem Getriebegehäuse (68) angeordnet ist.

## Claims

1. Control unit for a motor vehicle, said control unit comprising an electric SMD (surface-mounted device) component (4) having at least one corresponding connection pin (18, 30) and a circuit board (8),
wherein the circuit board (8) comprises at least one soldering area (12),
wherein the soldering area (12) is connected to the circuit board (8) in a non-detachable manner,
wherein the soldering area (12) and the connection pin (18, 30) can be connected to one another in a bonded, electrically conductive manner by means of a soldering process,
**characterized in that**:
a contact-making holding-device (40) is fixedly connected to the circuit board (8),
wherein the connection pin (18, 30) is positioned by means of the contact-making holding-device (40) in such a manner that if the connection pin (18, 30) is bonded to the soldering area (12), the connection pin (18, 30) and the circuit board (8) are at a predefined spacing (A) from one another, and
the contact-making holding-device (40) is connected to a first chamber wall (56) and a second chamber wall (58) in a non-detachable manner,
wherein the first chamber wall (56) and the second chamber wall (58) extend essentially parallel to one another,
wherein the first chamber wall (56) and the second chamber wall (58) are spaced apart from one another,
wherein the first chamber wall (56) and the second chamber wall (58) extend essentially parallel to a longitudinal extension direction (L) of the connection pin (18),
wherein the first chamber wall (56) and the second chamber wall (58) extend essentially perpendicular to an upper face (54) of the circuit board (8),
wherein the first chamber wall (56) and the second chamber wall (58) are fixedly connected to the circuit board (8),
wherein the connection pin (18) extends between the first chamber wall (56) and the second chamber wall (58).

2. Control unit according to Claim 1,
**characterized in that**:
the connection pin (18, 30) comprises a first surface (42) and a second surface (44) that lies opposite the first surface (42),
wherein the first surface (42) faces the soldering area (12),
wherein the second surface (44) is acted upon by means of the contact-making holding-device (40).

3. Control unit according to Claim 2,
**characterized in that**:
the second surface (44) comprises a first part surface (46) and a second part surface (48) that is adjacent to the first part surface (46),
wherein the first part surface (46) extends towards a casing (50) of the electric SMD component (4),
wherein the second part surface (48) extends away from the casing (50) of the electric SMD component (4),
wherein the soldering process is performed on the second part surface (48) by means of a method that is selected from the group: a laser beam soldering method, a light beam soldering method and a thermode soldering method.

4. Control unit according to Claim 3,
**characterized in that**:
the first chamber wall (56), the second chamber wall (58) and the contact-making holding-down device (40) are embodied in a frame (62),
wherein the electric SMD component (4) is surrounded by the frame (62) in an annular manner.

5. Control unit according to Claim 4,
**characterized in that**:
the frame (62) is fixedly connected to the circuit board (8).

6. Control unit according to Claim 4 or 5,
**characterized in that**:
the frame (62) is produced from an electrically non-conductive material.

7. Control unit according to any one of Claims 4 to 6,
**characterized in that**:
a component holding-down device (64) is fixedly connected to the frame (62),
wherein the electric SMD component (4) is pushed down in the direction (Z) of the circuit board (8) by means of the component holding-down device (64) .

8. Control unit according to any one of the preceding claims,
**characterized in that**:
the circuit board (8) is connected to a carrier plate (6) in a non-detachable manner,
wherein the circuit board (8) comprises an aperture (28),
wherein the electric SMD component (4) is arranged in the aperture (28),
wherein the electric SMD component (4) is connected to the carrier plate (6) in a thermally efficient conductive manner.

9. Automatic transmission having a control unit according to any one of the preceding claims,
**characterized in that**:
the automatic transmission (68) comprises a transmission housing (68),
wherein the control unit (2) is arranged in the transmission housing (68).

## Revendications

1. Appareil de commande pour un véhicule automobile, l'appareil de commande comportant un composant électrique SMD (surface-mounted device) (4) doté d'au moins une broche de raccordement (18, 30) correspondante et d'une carte de circuit imprimé (8),
dans lequel la carte de circuit imprimé (8) présente au moins une surface de brasage (12),
dans lequel la surface de brasage (12) est reliée de manière non amovible à la carte de circuit imprimé (8), dans lequel la surface de brasage (12) et la broche de raccordement (18, 30) sont reliées l'une à l'autre de manière électriquement conductrice au moyen d'un procédé de brasage,
**caractérisé en ce qu'**un serre-flan de contact (40) est fermement relié à la carte de circuit imprimé (8),
dans lequel la broche de raccordement (18, 30) est positionnée par le serre-flan de contact (40) de telle manière que, lorsque la broche de raccordement (18, 30) est reliée à la surface de brasage (12) par complémentarité de matériau, la broche de raccordement (18, 30) et la carte de circuit imprimé (8) sont à une distance prédéterminée (A) l'une de l'autre, et le serre-flan de contact (40) est relié de manière non amovible à une première paroi de chambre (56) et à une deuxième paroi de chambre (58),
dans lequel la première paroi de chambre (56) et la deuxième paroi de chambre (58) s'étendent sensiblement parallèlement l'une à l'autre,
dans lequel la première paroi de chambre (56) et la deuxième paroi de chambre (58) sont espacées l'une de l'autre,
dans lequel la première paroi de chambre (56) et la deuxième paroi de chambre (58) s'étendent sensiblement parallèlement à une direction d'extension longitudinale (L) de la broche de raccordement (18),
dans lequel la première paroi de chambre (56) et la deuxième paroi de chambre (58) s'étendent sensiblement perpendiculairement à une face supérieure (54) de la carte de circuit imprimé (8),
dans lequel la première paroi de chambre (56) et la deuxième paroi de chambre (58) sont fermement reliées à la carte de circuit imprimé (8),
dans lequel la broche de raccordement (18) s'étend entre la première paroi de chambre (56) et la deuxième paroi de chambre (58).

2. Appareil de commande selon la revendication 1,
**caractérisé en ce que** la broche de raccordement (18, 30) présente une première surface (42) et une deuxième surface (44) opposée à la première surface (42),
dans lequel la première surface (42) est tournée vers la surface de brasage (12),
dans lequel la deuxième surface (44) est sollicitée par le serre-flan de contact (40).

3. Appareil de commande selon la revendication 2,
**caractérisé en ce que** la deuxième surface (44) comporte une première surface partielle (46) et une deuxième surface partielle (48) adjacente à la première surface partielle (46),
dans lequel la première surface partielle (46) est tournée vers un boîtier (50) du composant électrique SMD (4),
dans lequel la deuxième surface partielle (48) est tournée à l'opposé du boîtier (50) du composant électrique SMD (4),
dans lequel le processus de brasage peut être réalisé sur la deuxième surface partielle (48) au moyen d'un procédé choisi dans le groupe constitué par le brasage par faisceau laser, le brasage par faisceau lumineux et le thermosoudage.

4. Appareil de commande selon la revendication 3,
**caractérisé en ce que** la première paroi de chambre (56), la deuxième paroi de chambre (58) et le serre-flan de contact (40) sont réalisés dans un châssis (62),
dans lequel le composant SMD électrique (4) est entouré sous forme annulaire par le châssis (62).

5. Appareil de commande selon la revendication 4,
**caractérisé en ce que** le châssis (62) est solidement relié à la carte de circuit imprimé (8).

6. Appareil de commande selon la revendication 4 ou 5,
**caractérisé en ce que** le châssis (62) est constitué d'un matériau électriquement non conducteur.

7. Appareil de commande selon l'une des revendications 4 à 6,
**caractérisé en ce qu'**un serre-flan pour composant (64) est fermement relié au châssis (62),
dans lequel le composant SMD électrique (4) est enfoncé par le serre-flan pour composant (64) dans la direction (Z) de la carte de circuit imprimé (8).

8. Appareil de commande selon l'une des revendications précédentes,
**caractérisé en ce que** la carte de circuit imprimé (8) est reliée de manière non amovible à une plaque support (6), dans lequel la carte de circuit imprimé (8) présente une ouverture (28),
dans lequel le composant SMD électrique (4) est disposé dans l'ouverture (28),
dans lequel le composant SMD électrique (4) est relié de manière à présenter une bonne conductivité thermique à la plaque de support (6).

9. Transmission automatique comportant un appareil de commande selon l'une des revendications précédentes,
**caractérisée en ce que** la transmission automatique (68) comporte un carter de transmission (68),
dans lequel l'appareil de commande (2) est disposé dans le carter de transmission (68).
